# EUROPEAN PATENT APPLICATION

(11) **EP 3 242 289 A1**
(43) Date of publication of application: **08.11.2017**
(21) Application number: 15801310.2
(22) Date of filing: 17.06.2015
(51) Int. Cl.: G09G 3/36, G11C 19/28

(54) **SHIFT REGISTER UNIT AND DRIVE METHOD, GRID DRIVE CIRCUIT AND DISPLAY DEVICE**

(30) Priority: 04.01.2015 CN 201510002311
(71) Applicant: BOE Technology Group Co., Ltd., Beijing Beijing 100015 (CN); Ordos Yuansheng Optoelectronics Co., Ltd., Ordos, Inner Mongolia 017020 (CN)
(72) Inventor: LI, Fuqiang, Beijing 100176 (CN); LI, Cheng, Beijing 100176 (CN)
(74) Representative: Klunker IP Patentanwälte PartG mbB
(86) International application number: PCT/CN2015/081624
(87) International publication number: WO 2016/107096

(57) **Abstract**

A shift register unit, a driving method thereof, a gate driving circuit and a display device, wherein the shift register unit includes a pull-up module (50), a first input module (20), a second input module (30), a pull-down control module (10) and a pull-down module (40). By such a shift register unit, it can be avoided that a scan signal is outputted to the corresponding gate line during the non-output phase in error, improving the stability and reliability of the circuit.

## Description

### TECHNICAL FIELD OF THE DISCLOSURE

The present disclosure relates to the field of display technologies; in particular, to a shift register unit and driving method thereof, a gate driving circuit and a display device.

### BACKGROUND

LCD (Liquid Crystal Display) has advantages such as low radiation, small size and low power consumption, and is widely applied to electronic products such as notebook computers, flat screen televisions, mobile phones, or the like. The LCD comprises a matrix formed by pixels arranged in the horizontal direction and the vertical direction. When the LCD performs displaying, the data driving circuit can latch the input display data and the clock signals sequentially in time and convert them into analogue signals to be input to the data lines of the liquid crystal (LC) panel, and the gate driving circuit can convert the input clock signals into voltages for controlling on/off of the pixels through shift registers and apply the voltages to the gate lines of the LC panel row by row.

In order to further reduce the fabrication cost of the LCD products, existing gate driving circuits usually use the GOA (Gate Driver on Array) design to integrate the TFT (Thin Film Transistor) gate switching circuit on the array substrate of the display panel to scan and drive the display panel, thereby it is possible to omit the part of integrated circuit for gate driving. Such a gate switching circuit integrated on the array substrate through the GOA technology is also referred to as a GOA circuit or a shift register circuit.

In an existing GOA circuit, a pull-up node PU and a pull-down node PD are arranged, wherein, the pull-up node PU is used to control the shift register unit to output a scan signal to a corresponding gate line, and the pull-down node PD is used to control the shift register unit not to output the scan signal to the corresponding gate line during the non-output phase. However, such a GOA circuit comprises multiple TFTs, the defect in the fabrication process of the array substrate will result in the adverse phenomena of leakage current (I_{off}) or threshold voltage drift (Vth drift) occurring in the TFTs on the array substrate. In consequence, during the procedure of pulling up the potential, the potential of the pull-down node PD will be pulled down due to the leakage current and the threshold voltage drift of the TFTs, causing the shift register unit to output a scan signal in error to the corresponding gate line in the non-output phase, reducing the stability and reliability of the GOA circuit.

### SUMMARY

Embodiments of the present disclosure provide a shift register unit, a driving method, a gate driving circuit and a display device, which can prevent the shift register unit from wrongly outputting a scan signal to the corresponding gate line during the non-output phase.

Accordingly, embodiments of the present disclosure adopt the following technical solutions.

According to an aspect of embodiments of the present disclosure, there is provided a shift register unit comprising a pull-up module, a first input module, a second input module, a pull-down control module and a pull-down module, wherein
the pull-up module is connected to a pull-up node, a first clock signal terminal and a signal output terminal , and used to transmit a signal input from the first clock signal terminal to the signal output terminal under the control of the pull-up node;
the first input module is connected to a first signal input terminal, a first voltage terminal and the pull-up node, and used to pull the voltage of the pull-up node to the voltage of the first voltage terminal under the control of the signal input from the first signal input terminal;
the second input module is connected to a second signal input terminal, a second voltage terminal and the pull-up node, and used to pull the voltage of the pull-up node to the voltage of the second voltage terminal under the control of the signal input from the second signal input terminal;
the pull-down control module is connected to the second clock signal terminal, the pull-up node, a pull-down node and a third voltage terminal, and used to pull the voltage of the pull-down node to the voltage of the third voltage terminal under the control of the pull-up node, or input the signal input from the second clock signal terminal to the pull-down node under the control of the signal input from the second clock signal terminal; and
the pull-down module is connected to the pull-down node, the pull-up node, the signal output terminal and the third voltage terminal, and used to pull the potential of the pull-up node and the output voltage of the signal output terminal to the voltage of the third voltage terminal under the control of the pull-down node.

According to another aspect of embodiments of the present disclosure, there is provided a gate driving circuit comprising at least two stages of shift register units described in the above;
except the first stage of shift register unit, the first signal input terminal of each stage of shift register unit is connected to the signal output terminal of its adjacent previous stage of shift register unit; and
except the last stage of shift register unit, the second signal input terminal of each stage of shift register unit is connected to the signal output terminal of its adjacent next stage of shift register unit.

According to another aspect of embodiments of the present disclosure, there is provided a display device comprising any gate driving circuit described in the above.

According to another aspect of embodiments of the present disclosure, there is provided a driving method for driving any shift register unit described in the above, comprising:
in a first phase, the first input module pulling the potential of the pull-up node to the voltage of the first voltage terminal through the signal input from the first signal input terminal, and the pull-down control module pulling the potential of the pull-down node to the voltage of the third voltage terminal under the control of the pull-up node;
in a second phase, the pull-up node turning on the pull-up module such that the signal input from the first clock signal terminal is transmitted to the signal output terminal, and the pull-down control module maintaining the potential of the pull-down node at the voltage of the third voltage terminal under the control of the pull-up node; and
in a third phase, the second input module pulling the potential of the pull-up node to the voltage of the second voltage terminal through the signal input from the second signal input terminal, and the pull-up module being turned off under the control of the pull-up node; and
the second clock signal terminal turning on the pull-down control module, and transmitting the signal input from the second clock signal terminal to the pull-down node, and the pull-down module pulling the potential of the pull-up node and the signal of the signal output terminal to the voltage of the third voltage terminal under the control of the potential of the pull-down node.

Embodiments of the present disclosure provide a shift register unit, a driving method, a gate driving circuit and a display device. The shift register unit comprises a pull-up module, a first input module, a second input module, a pull-down control module and a pull-down module. In such a way, it is possible to control the potential of the pull-up node through the first input module and the second input module. When the potential of the pull-up node is pulled up, the pull-up module can be turned on, such that the signal input from the first clock signal terminal is output from the signal output terminal as a scan signal to scan the gate line corresponding to the shift register unit. When the potential of the pull-up node is pulled down, the potential of the pull-down node can be pulled up by the pull-down control module to turn on the pull-down module under the control of the pull-down node, further to pull down the potential of the pull-up node and/or the signal output from the signal output terminal , such that it is possible to ensure that no scan signal is output during the non-output phase of the shift register unit. When the potential of the pull-up node is pulled down during the non-output phase of the shift register unit, the potential of the pull-down node can be maintained in the high level state by the pull-down control module. Therefore, it is possible to avoid the potential of the pull-down node being pulled down due to the leakage current and the threshold voltage drift of the TFT and in turn to prevent the shift register unit from outputting the scan signal to the corresponding gate line during the non-output phase in error, thus improving the stability and the reliability of the GOA circuit.

### BRIEF DESCRIPTION OF THE DRAWINGS

In order to describe known technical solutions or embodiments of the present disclosure more clearly, figures which are needed to be used in the descriptions of the embodiments and known technical solutions are briefly introduced in the following. Obviously, figures in the following description only illustrate some embodiments of the present disclosure. Those skilled in the art can obtain other figures on the basis of these figures without creative work.
Fig. la is a schematic structural diagram of a shift register unit provided by an embodiment of the present disclosure;
Fig. 1b is a schematic structural diagram of another shift register unit provided by an embodiment of the present disclosure;
Fig. 2 is a schematic structural diagram of a gate driving circuit provided by an embodiment of the present disclosure;
Fig. 3 is a schematic structural diagram of another shift register unit provided by an embodiment of the present disclosure;
Fig. 4 is a timing sequence diagram of signals in the operation of a shift register unit provided by an embodiment of the present disclosure;
Fig. 5 is a schematic structural diagram of another shift register unit provided by an embodiment of the present disclosure;
Fig. 6 is a schematic structural diagram of yet another shift register unit provided by an embodiment of the present disclosure; and
Fig. 7 is a schematic structural diagram of yet another shift register unit provided by an embodiment of the present disclosure.

### DETAILED DESCRIPTION

In the following, technical solutions in embodiments of the present disclosure will be clearly and completely described in connection with figures. Obviously, the described embodiments are only part of embodiments of the present disclosure, rather than all the embodiments. Based on the embodiments in the present disclosure, all other embodiments obtained by those skilled in the art without creative work all belong to the protection scope of the present disclosure.

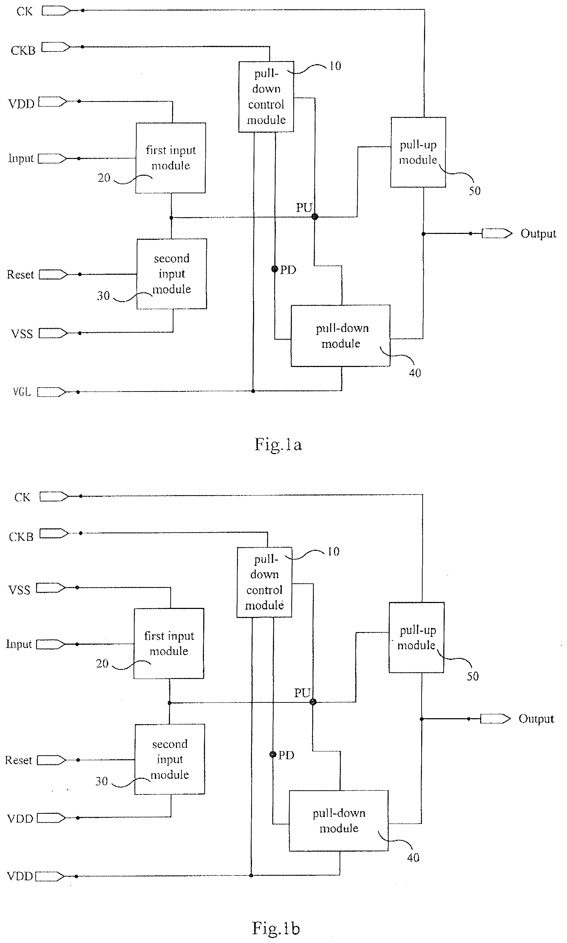

An embodiment of the present disclosure provides a shift register unit, as shown in Fig. 1a, which can comprise a pull-up module 50, a first input module 20, a second input module 30, a pull-down control module 10 and a pull-down module 40.

The pull-up module 50 is connected to a pull-up node PU, a first clock signal terminal CK and a signal output terminal Output respectively, and used to transmit a signal input from the first clock signal terminal CK to the signal output terminal Output under the control of the pull-up node PU.

The first input module 20 is connected to a first signal input terminal Input, a first voltage terminal VDD and the pull-up node PU, and used to pull up the voltage of the pull-up node PU to the voltage of the first voltage terminal VDD under the control of the input signal of the first signal input terminal Input.

The second input module 30 is connected to a second signal input terminal Reset, a second voltage terminal VSS and the pull-up node PU, and used to pull down the voltage of the pull-up node PU to the voltage of the second voltage terminal VSS under the control of the input signal of the second signal input terminal Reset.

The pull-down control module 10 is connected to the second clock signal terminal CKB, the pull-up node PU, a pull-down node PD and a third voltage terminal VGL, and used to pull down the voltage of the pull-down node PD to the voltage of the third voltage terminal VGL under the control of the pull-up node PU, or to input the input signal of the second clock signal terminal CKB to the pull-down node PD under the control of the input signal of the second clock signal terminal CKB.

The pull-down module 40 is connected to the pull-down node PD, the pull-up node PU, the signal output terminal Output and the third voltage terminal VGL, and used to pull down the potential of the pull-up node PU and/or the output voltage of the signal output terminal Output to the voltage of the third voltage terminal VGL under the control of the pull-down node PD.

It is noted that at least two stages of shift register units (SR0, SR1...SRn) as described in the above can constitute a gate driving circuit.

Except the first stage of shift register unit SR0, the first signal input terminal Input of each stage of shift register unit is connected to the signal output terminal Output of its adjacent previous stage of shift register unit. The first signal input terminal Input of the first stage of shift register unit SR0 receives a start signal STV.

Except the last stage of shift register unit SRn, the second signal input terminal Reset of each stage of shift register unit is connected to the signal output terminal Output of its adjacent next stage of shift register unit. The second signal input terminal Reset of the last stage of shift register unit SRn can input a reset signal RST.

It is also noted that the number of the shift register units is the same as the number of gate lines in the display area. In other words, the signal output terminal Output of each stage of shift register unit is connected to one row of gate lines in the display area, so as to shift the input scan signal through multiple stages of shift registers to scan the gate lines row by row. The gate driving circuit provided by the present disclosure can also realize scanning in different directions according to the input position of the start signal STV.

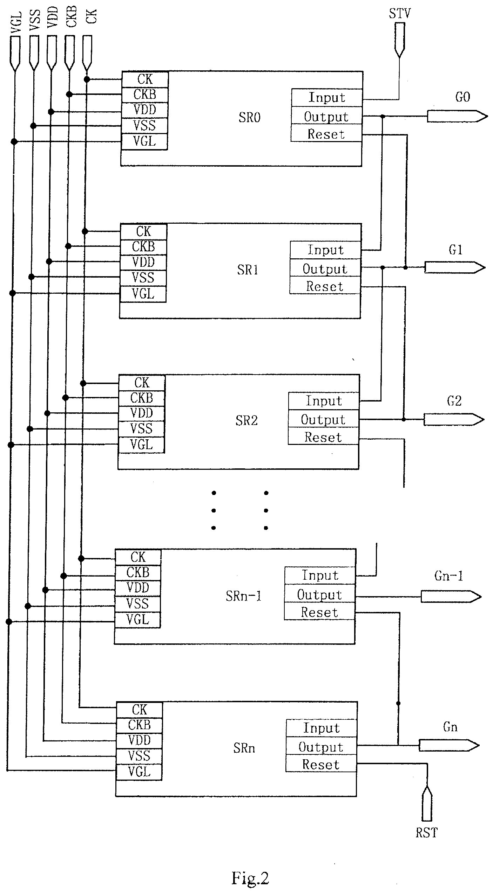

In particular, as shown in Fig. 2, when the first signal input terminal Input of the first stage of shift register unit SR0 among respectively shift register units (SR0, SR1...SRn) in the above gate driving circuit receives the start signal STV, and the second signal input terminal Reset of the last stage of shift register unit SRn inputs the reset signal RST, the signal output terminals Output of the respective stages of shift register units (SR0, SR1...SRn) output the scan signals sequentially in a forward direction (from the top to the bottom) to their corresponding gate lines (G0, G1, G2...Gn).

When the second signal input terminal Reset of the last stage of shift register unit SRn among the respective stages of shift register units (SR0, SR1...SRn) in the above gate driving circuit receives the start signal STV, and the first signal input terminal Input of the first stage of shift register unit SR0 inputs the reset signal RST, the signal output terminals Output of the respective stages of shift register units output the scan signals sequentially in a reverse direction (from the bottom to the top) to their corresponding gate lines (Gn, Gn-1...G0).

In order to realize the above scanning in the reverse direction, it is also needed to exchange the connection positions of the first voltage terminal VDD and the second voltage terminal VSS (or the third voltage terminal VGL) in Fig. 1a.

In particular, as shown in Fig. 1b, it is possible to connect the modules, which arc connected to the second voltage terminal VSS and the third voltage terminal VGL previously, to the first voltage terminal VDD; for example, it is possible to connect the second input module 20, which is connected to the second voltage terminal VSS previously, to the first voltage terminal VDD, and to connect the pull-down control module 10 and the pull-down module 40, which are connected to the third voltage terminal VGL previously, to the first voltage terminal VDD. In addition, it is also needed to connect the modules, which are connected to the first voltage terminal VDD previously, for example, the first input module 20, to the second voltage terminal VSS or the third voltage terminal VGL.

The above gate driving circuit has the same advantageous effect as the shift register unit in the previous embodiments, which will not be described repeatedly since the structure and advantageous effect of the shift register unit has been described.

It is further noted that embodiments of the present disclosure are described by taking an example in which the first voltage terminal VDD inputs a high level, and the second voltage terminal VSS and the third voltage terminal VGL input low levels for illustration.

An embodiment of the present disclosure provides a shift register unit comprising a pull-up module, a first input module, a second input module, a pull-down control module and a pull-down module. In such a way, it is possible to control the potential of the pull-up node through the first input module and the second input module. When the potential of the pull-up node is pulled up, the pull-up module can be turned on, such that the signal input from the first clock signal terminal is output from the signal output terminal as a scan signal so as to scan the gate line corresponding to the shift register unit. When the potential of the pull-up node is pull-down, the potential of the pull-down node can be pulled up by the pull-down control module to turn on the pull-down module under the control of the pull-down node, further to pull down the potential of the pull-up node and/or the output signal of the signal output terminal, such that it is possible to ensure that no scan signal is output from the shift register unit during the non-output phase. During the non-output phase of the shift register unit, the potential of the pull-up node is pulled down, such that the potential of the pull-down node can remain in the high level state by the pull-down control module. Therefore, it is possible to avoid the potential of the pull-down node being pulled down due to the leakage current and the threshold voltage drift of the TFT and in turn to prevent the shift register unit from outputting the scan signal to the corresponding gate line during the non-output phase in error, thus improving the stability and the reliability of the GOA circuit.

In the following, detailed descriptions on the specific structures of the shift register units illustrated in other figures are made exemplarily in multiple embodiments. Shift register units with other connection manners can be obtained likely, which are not described here one by one.

### Embodiment 1

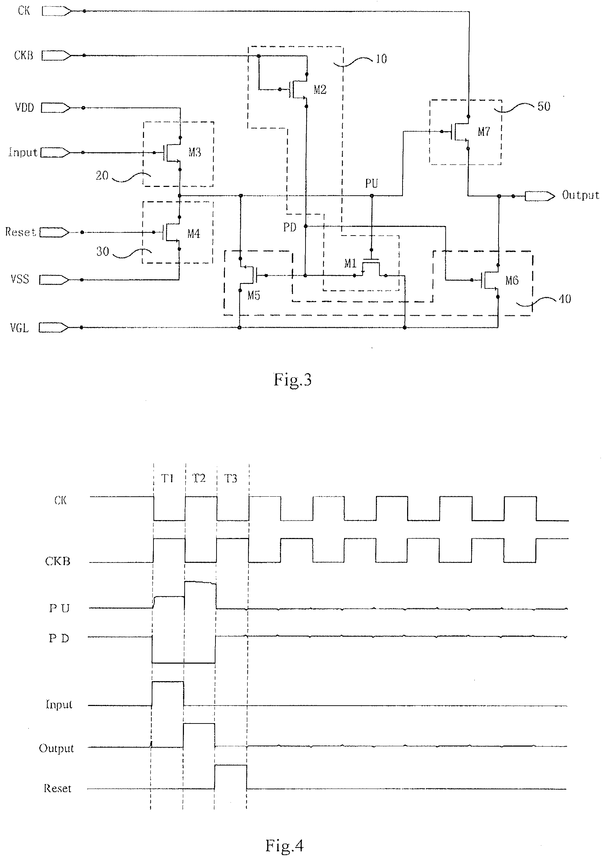

As shown in Fig. 3, the pull-down control module 10 can comprise a first transistor M1 and a second transistor M2.

A gate of the first transistor M1 is connected to the pull-up node PU, a first electrode of the first transistor is connected to the third voltage terminal VGL, and a second electrode of the first transistor is connected to the pull-down node PD.

In particular, during the output phase of the shift register unit, in order to ensure that the signal output terminal can output the scan signal, the potential of the pull-up node PU needs to remain in the high level state, such that the first transistor M1 can be turned on under the control of the pull-up node PU to pull down the potential of the pull-down node PD to the voltage of the third voltage terminal VGL through the first transistor M1. Therefore, it is possible to prevent the potential of the pull-up node PU from being pulled down by the pull-down module 40 due to the rising of the potential of the pull-down node PD.

A gate and a first electrode of the second transistor M2 are connected to the second clock signal terminal CKB, and a second electrode of the second transistor is connected to the pull-down node PD.

In particular, when the potential of the pull-up node is pulled down during the non-output phase of the shift register unit, the signal input from the second clock signal terminal CKB can turn on the second transistor M2 to transmit the signal input from the second clock signal terminal CKB to the pull-down node PD through the second transistor M2 and maintain the potential of the pull-down node PD in the high level state. In such a way, the pull-down node PD can turn on the pull-down module 40 to pull down the potential of the pull-up node PU and the output signal of the signal output terminal Output.

In view of the above, when the potential of the pull-up node is pulled down during the non-output phase of the shift register unit, the potential of the pull-down node PD can be maintained in the high level state by the pull-down control module 10. Therefore, it is possible to avoid the potential of the pull-down node being pulled down due to the leakage current and the threshold voltage drift of the TFT and in turn to prevent the shift register unit from outputting the scan signal to the corresponding gate line during the non-output phase in error, thus improving the stability and the reliability of the GOA circuit.

The first input module 20 can comprise a third transistor M3 whose gate is connected to the first signal input terminal Input, whose first electrode is connected to the first voltage terminal VDD, and whose second electrode is connected to the pull-up node PU.

In particular, after the signal input from the first signal input terminal Input turns on the third transistor M3, the potential of the pull-up node PU can be pulled up to the voltage of the first voltage terminal VDD via the third transistor M3.

The second input module 30 can comprise a fourth transistor M4 whose gate is connected to the second signal input terminal Reset, whose first electrode is connected to the pull-up node PU, and whose second electrode is connected to the second voltage terminal VSS.

In particular, after the signal input from the second signal input terminal Reset turns on the fourth transistor M4, the potential of the pull-up node PU can be pulled down to the voltage of the second voltage terminal VSS via the fourth transistor M4.

The pull-down module 40 can comprise a fifth transistor M5 and a sixth transistor M6.

A gate of the fifth transistor M5 is connected to the pull-down node PD, a first electrode of the fifth transistor M5 is connected to the third voltage terminal VGL, and a second electrode of the fifth transistor M5 is connected to the pull-up node PU.

In particular, under the control of the pull-down node PD, the fifth transistor M5 can be turned on to pull down the potential of the pull-up node PU to the voltage of the third voltage terminal VGL through the fifth transistor M5.

A gate of the sixth transistor M6 is connected to the pull-down node PD, a first electrode of the sixth transistor M6 is connected to the signal output terminal Output, and a second electrode of the sixth transistor is connected to the third voltage terminal VGL.

In particular, under the control of the pull-down node PD, the sixth transistor M6 can be turned on to pull down the signal output by the signal output terminal Output to the voltage of the third voltage terminal VGL through the sixth transistor M6.

The pull-up module 50 can comprise a seventh transistor M7 whose gate is connected to the pull-up node PU, whose first electrode is connected to the first clock signal terminal CK and whose second electrode is connected to the signal output terminal Output.

In particular, under the control of the pull-up node PU, the seventh transistor M7 can be turned on to output the signal input from the first clock signal terminal CK to the signal output terminal Output through the seventh transistor M7 as the scan signal to scan the gate line corresponding to the shift register unit.

It is noted that all transistors in the embodiments of the present disclosure are described by taking N type transistors as an example. The first electrode of the transistor can be a drain, and the second electrode can be a source. Since the source and the drain of the transistor used herein arc symmetrical, the source and the drain can be exchangeable. In embodiments of the present disclosure, in order to distinguish the two electrodes other than the gate of the transistor, one of the two electrodes is referred to as the source and the other of the two electrodes is referred to as the drain. If the source is selected to function as the signal input terminal, the drain functions as the signal output terminal, and vice versa.

In the following, the operation process of the shift register unit as illustrated in Fig. 3 is described in detail in connection with the timing sequence diagram of the shift register unit, as shown in Fig. 4.

In a first phase T1, CK=0; CKB=1; PU=1; PD=0; Input=1; Output=0; Reset=0. It is noted that "0" represents a low level and "1" represents a high level in the following embodiments.

The first signal input terminal Input inputs the high level to turn on the third transistor M3 and pull up the potential of the pull-up node PU to the high level input from the first voltage terminal VDD through the third transistor M3. At the same time, the high level input from the first voltage terminal VDD charges the parasitic capacitance of the seventh transistor M7.

Because the potential of the pull-up node PU is at the high level, the first transistor M1 is turned on such that the potential of the pull-down node PD can be pulled down to the low level input from the third voltage terminal VGL via the first transistor M1. Because the potential of the pull-down node PD is at the low level, both the fifth transistor M5 and the sixth transistor M6 are in the turned-off state.

It is noted that, in the first phase T1, because the PU is at the high level, the first transistor M1 is turned on. Although the terminal CKB inputs the high level now and the second transistor M2 is turned on, the size ratio of the first transistor M1 to the second transistor M2 is designed such that the potential of the pull-down node PD is still at the low level in a case in which both the transistors are tuned on.

In the second phase T2, CK=1; CKB=0; PU=1; PD=0; Input=0; Output=1; Reset=0.

The first signal input terminal Input and the second signal input terminal Reset input the low level, and the third transistor and the fourth transistor are in the turned-off state. The potential of the pull-up node PU is further pulled up due to the bootstrap effect of the parasitic capacitance of the seventh transistor M7. The seventh transistor M7 is turned on to transmit the high level input from the first clock signal terminal CK to the signal output terminal Output as the scan signal to scan the gate line corresponding to the shift register unit.

In addition, like the first phase T1, because the potential of the pull-up node PU is the high level, it is possible to maintain the potential of the pull-down node PD to be at the low level input from the third voltage terminal VGL through the first transistor M1. In this case, both the fifth transistor M5 and the sixth transistor M6 are in the turned-off state.

In the third phase T3, CK=0; CKB=1; PU=0; PD=1; Input=0; Output=0; Reset=1.

The first signal input terminal Input inputs the low level, and the third transistor M3 is in the turned-off state. The second signal input terminal Reset inputs the high level, and the fourth transistor M4 is in the turned-on state, such that it is possible to pull down the potential of the pull-up node PU to the low level input from the second voltage terminal VSS through the fourth transistor M4. In this case, the seventh transistor M7 is in the turned-off state.

The second clock signal input terminal CKB inputs the high level to turn on the second transistor M2 and transmit the high level input from the second clock signal input terminal CKB to the pull-down node PD through the second transistor M2. Under the control of the potential of the pull-down node PD, it is possible to turn on the fifth transistor M5 and the sixth transistor M6. The potential of the pull-up node PU can be pulled down to the low level input from the third voltage terminal VGL via the fifth transistor M5, such that it is possible to avoid the potential of the pull-up node PU being wrongly pulled up to turn on the seventh transistor M7 in error. At the same time, the sixth transistor M6 can pull down the signal output by the signal output terminal Output to the low level input from the third voltage terminal VGL, such that it is possible to avoid that the signal output terminal Output wrongly outputs the scan signal to the gate line during the non-output phase of the shift register unit.

It is noted that the phases T1∼T3 can be referred to as the operation time of the shift register unit. The signal output terminal Output can output the high level only during the second phase T2; therefore the second phase T2 can be referred to as the data output phase of the shift register unit. The first phase T1 and the third phase T3 are referred to as the non-output phase of the shift register unit, during which the signal output terminal Output outputs the low level.

In addition, the above transistors (T1∼T7) can also all be P type transistors. In a case in which the transistors in the shift register unit and the transistors in the pixel unit which are connected with the gate line are all P type transistors, it is needed to accordingly adjust the timing sequence of the driving signal and the input signals of the circuit.

In particular, it is possible to connect the modules or transistors, which are connected with the second voltage terminal VSS and the third voltage terminal VGL as illustrated in Fig. 3, to the first voltage terminal VDD, and connect the modules or transistors, which are connected with the first voltage terminal VDD as illustrated in Fig. 3, to the second voltage terminal VSS or the third voltage terminal VGL. In addition, it is needed to reverse the direction of the driving signal in Fig. 4. The specific operation process is similar to that described in the above, which will not be repeated herein.

### Second Embodiment

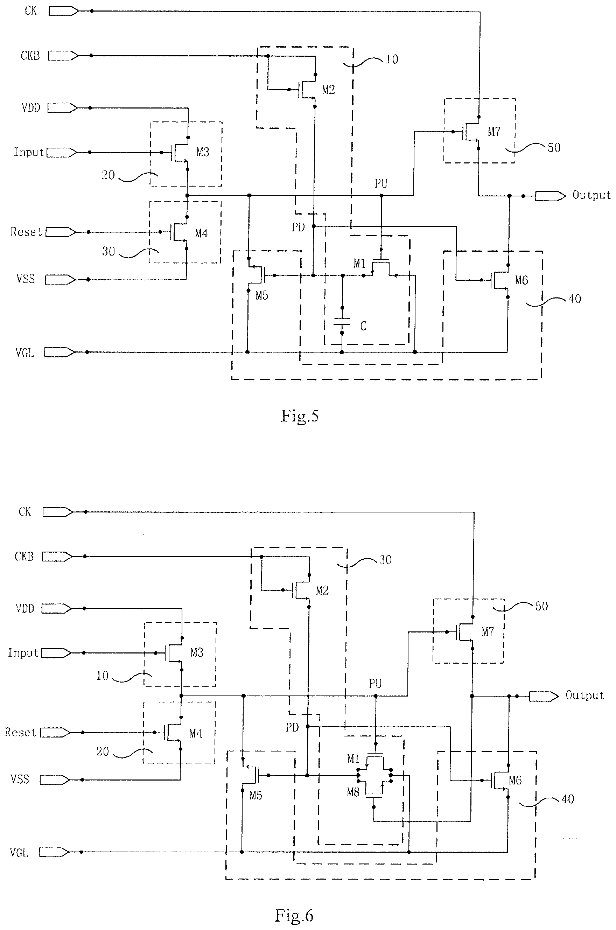

On the basis of the first embodiment, the pull-down control module 10 as illustrated in Fig. 5 can further comprise a capacitor C.

One terminal of the capacitor C is connected to the pull-down node PD, and another terminal thereof is connected to the third voltage terminal VGL.

In such a way, after the signal output terminal Output outputs the scan signal to the gate line, that is, after entering the third phase T3, it is possible to maintain the pull-down node PD to be in the high level state through the storage effect of the capacitor C, such that it is possible to avoid the potential of the pull-up node PD decreasing due to the effect such the leakage current of the transistor or the like, reducing the noise at the potential of the pull-down node PD.

### Third Embodiment

On the basis of the first embodiment, the pull-down control module 10 as illustrated in Fig. 6 can further comprise an eighth transistor M8.

A gate of the eighth transistor M8 is connected to the signal output terminal Output , a first electrode is connected to the pull-down node PD and a second electrode is connected to the third voltage terminal VGL.

In the above second phase T2, the seventh transistor M7 is turned on. It is possible to transmit the high level input from the first clock signal terminal to the gate of the eighth transistor M8 whiling outputting the same to the signal output terminal Output , such that the eighth transistor M8 is turned on. In such a way, the first electrode of the eighth transistor M8 and the second electrode of the first transistor M1 are both connected to the pull-down node PD; therefore, the eighth transistor M8 and the first transistor M1 can pull down the potential of the pull-down node PD to the low level input from the third voltage terminal VGL together, such that it is possible to ensure that the potential of the pull-down node PD remains at the low level during the above second phase T2 (i.e., the data output phase of the shift register unit) to avoid turning on the fifth transistor M5 and the sixth transistor M6 in error and thus avoid pulling down the potential of the pull-up node PU and the output signal of the signal output terminal Output to the low level in error. Therefore, it is possible to improve the stability and reliability of the GOA circuit.

### Fourth Embodiment

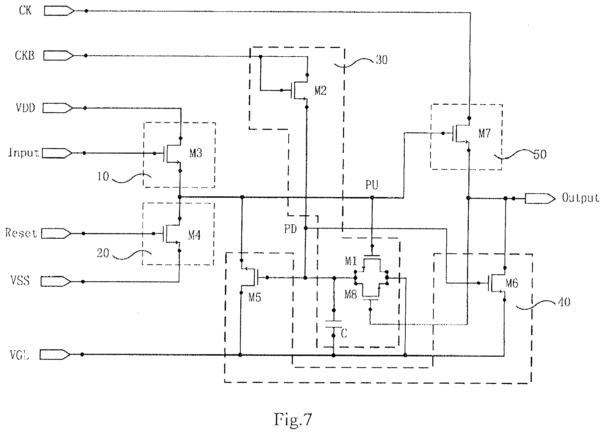

On the basis of the first embodiment, the pull-down control module 10 as illustrated in Fig. 7 can comprise both the above capacitor C and the eighth transistor M8. The advantageous effect of the fourth embodiment is same as that of the second embodiment, and the third embodiment, which will be not described repeatedly.

An embodiment of the present disclosure provides a display device comprising any gate driving circuit described in the above, which have the same advantageous effects as the gate driving circuit provided in the above embodiments of the present disclosure. The gate driving circuit has been described in detail in the above embodiment, which will not be described repeatedly here.

The display device can specifically be any LC display product or component such as a LC display, a LC television, a digital photo frame, a cell phone, a pad computer, etc.

An embodiment of the present disclosure provides a driving method for driving any shift register unit described in the above. The method can comprise the following steps.

In the first phase T1, CK=0; CKB=1; Input=1; Reset=0.

The first input module 20 pulls up the potential of the pull-up node PU to the voltage of the first voltage terminal VDD through the signal input from the first signal input terminal Input, and the pull-down control module 10 pulls down the potential of the pull-down node PD to the voltage of the third voltage terminal VGL under the control of the pull-up node PU, such as to avoid the pull-down node PD turning on the pull-down module 40.

In the second phase, CK=1; CKB=0; Input=0; Reset=0.

The pull-up node PU turns on the pull-up module 50 such that the signal input from the first clock signal terminal CK is transmitted to the signal output terminal Output as the scan signal to be output to the gate line corresponding to the shift register unit and scan the gate line; the pull-down control module 10 can maintain the potential of the pull-down node PD at the voltage of the third voltage terminal VGL under the control of the pull-up node PU, such as to avoid the pull-down node PD turning on the pull-down module 40.

In the third phase, CK=0; CKB=1; Input=0; Reset=1.

The second input module 30 pulls down the potential of the pull-up node PU to the voltage of the second voltage terminal VSS through the signal input from the second signal input terminal Reset. Because the second voltage terminal VSS inputs the low level, the potential of the pull-up node PU is the low level. The pull-up module 50 is turned off under the control of the pull-up node PU such that the signal output terminal Output does not output a scan signal during the non-output phase.

The second clock signal terminal CKB turns on the pull-down control module 10, and transmits the signal input from the second clock signal terminal CKB to the pull-down node PD. Because the second clock signal terminal CKB inputs the high level, the potential of the pull-down node PD is the high level. The pull-down module 40 pulls down the potential of the pull-up node PU and the signal of the signal output terminal Output respectively to the voltage of the third voltage terminal VGL under the control of the potential of the pull-down node PD, so as to ensure that the signal output terminal Output does not output the scan signal during the non-output phase.

It can be understood by those skilled in the art that all or part of the steps in the above method embodiments can be implemented by programs instructing related hardware. The programs can be stored in a computer accessible storage medium. The programs, when being executed, perform the steps of the above method embodiments. The above storage medium comprises any medium that can storage program codes, such as ROM, RAM, magnetic disc, optical disc or the like.

The above descriptions only illustrate specific implementations of the present disclosure, and the protection scope of the present disclosure is not limited to this. Modifications or replacements that can be easily devised by those skilled in the art within the technical scope of the present disclosure should all fall within the protection scope of the present disclosure. Therefore, the protection scope of the present disclosure should be defined by the protection scope of the claims.

The present application claims the priority of Chinese Patent Application No. 201510002311.6 filed on January 4, 2015, and the entire content of which is incorporated as part of the present application by reference.

## Claims

1. A shift register unit comprising a pull-up module, a first input module, a second input module, a pull-down control module and a pull-down module, wherein
the pull-up module is connected to a pull-up node, a first clock signal terminal and a signal output terminal, and configured to transmit a signal input from the first clock signal terminal to the signal output terminal under a control of the pull-up node;
the first input module is connected to a first signal input terminal, a first voltage terminal and the pull-up node, and configured to pull a voltage of the pull-up node to a voltage of the first voltage terminal under a control of a signal input from the first signal input terminal;
the second input module is connected to a second signal input terminal, a second voltage terminal and the pull-up node, and configured to pull the voltage of the pull-up node to a voltage of the second voltage terminal under a control of a signal input from the second signal input terminal;
the pull-down control module is connected to the second clock signal terminal, the pull-up node, a pull-down node and a third voltage terminal, and configured to pull a potential of the pull-down node to a voltage of the third voltage terminal under a control of the pull-up node, or input a signal input from the second clock signal terminal to the pull-down node under a control of the signal input from the second clock signal terminal; and
the pull-down module is connected to the pull-down node, the pull-up node, the signal output terminal and the third voltage terminal, and configured to pull a potential of the pull-up node and a voltage output from the signal output terminal to the voltage of the third voltage terminal.

2. The shift register unit according to claim 1, wherein the pull-down control module comprises a first transistor and a second transistor;
a gate of the first transistor is connected to the pull-up node, a first electrode of the first transistor is connected to the third voltage terminal, and a second electrode of the first transistor is connected to the pull-down node; and
a gate and a first electrode of the second transistor are connected to the second clock signal terminal, and a second electrode of the second transistor is connected to the pull-down node.

3. The shift register unit according to claim 2, wherein the pull-down control module further comprises:
an eighth transistor whose gate is connected to the signal output terminal , whose first electrode is connected to the pull-down node and whose second electrode is connected to the third voltage terminal.

4. The shift register unit according to claim 2 or 3, wherein the pull-down control module further comprises:
a capacitor, one terminal of which is connected to the pull-down node, and another terminal of which is connected to the third voltage terminal.

5. The shift register unit according to claim 1 or 2, wherein the first input module comprises:
a third transistor whose gate is connected to the first signal input terminal, whose first electrode is connected to the first voltage terminal, and whose second electrode is connected to the pull-up node.

6. The shift register unit according to claim 1 or 2, wherein the second input module comprises:
a fourth transistor whose gate is connected to the second signal input terminal, whose first electrode is connected to the pull-up node, and whose second electrode is connected to the second voltage terminal.

7. The shift register unit according to claim 1 or 2, wherein the pull-down module comprises a fifth transistor and a sixth transistor;
a gate of the fifth transistor is connected to the pull-down node, a first electrode of the fifth transistor is connected to the third electrode terminal, and a second electrode of the fifth transistor is connected to the pull-up node; and
a gate of the sixth transistor is connected to the pull-down node, a first electrode of the sixth transistor is connected to the signal output terminal, and a second electrode of the sixth transistor is connected to the third voltage terminal.

8. The shift register unit according to claim 1 or 2, wherein the pull-up module comprises:
a seventh transistor whose gate is connected to the pull-up node, whose first electrode is connected to the first clock signal terminal and whose second electrode is connected to the signal output terminal.

9. A gate driving circuit comprising at least two stages of shift register units according to any of claims 1-8;
except a first stage of shift register unit, the first signal input terminal of each stage of shift register unit is connected to the signal output terminal of its adjacent previous stage of shift register unit; and
except a last stage of shift register unit, the second signal input terminal of each stage of shift register unit is connected to the signal output terminal of its adjacent next stage of shift register unit.

10. A display device comprising the gate driving circuit according to claim 9.

11. A driving method for driving the shift register unit according to any of claims 1-8, wherein
in a first phase, the potential of the pull-up node is pulled by the first input module to the voltage of the first voltage terminal through the signal input from the first signal input terminal, and the potential of the pull-down node is pulled by the pull-down control module to the voltage of the third voltage terminal under the control of the pull-up node;
in a second phase, the pull-up module is turned on by the pull-up node such that the signal input from the first clock signal terminal is transmitted to the signal output terminal , and the potential of the pull-down node is maintained by the pull-down control module at the voltage of the third voltage terminal under the control of the pull-up node; and
in a third phase, the potential of the pull-up node is pulled by the second input module to the voltage of the second voltage terminal through the signal input from the second signal input terminal, and the pull-up module is turned off under the control of the pull-up node; and
the pull-down control module is turned on by the second clock signal terminal, and the signal input from the second clock signal terminal is transmitted to the pull-down node, and the potential of the pull-up node and the signal of the signal output terminal are pulled by the pull-down module respectively to the voltage of the third voltage terminal under the control of the potential of the pull-down node.
